**Europäisches Patentamt**

**European Patent Office**

**Office européen des brevets**

(19)

(11) Veröffentlichungsnummer: **0 138 008 B1**

(12)

# EUROPÄISCHE PATENTSCHRIFT

(45) Veröffentlichungstag der Patentschrift:
**26.10.88**

(51) Int. Cl.⁴: **H 03 L 7/18**

(21) Anmeldenummer: **84110371.6**

(22) Anmeldetag: **31.08.84**

(54) **Verfahren und Anordnung zum Einstellen und Regeln der Frequenz eines Signalgenerators.**

(30) Priorität: **13.10.83 DE 3337283**

(43) Veröffentlichungstag der Anmeldung:
**24.04.85 Patentblatt 85/17**

(45) Bekanntmachung des Hinweises auf die Patenterteilung:
**26.10.88 Patentblatt 88/43**

(84) Benannte Vertragsstaaten:
**AT CH DE LI NL**

(56) Entgegenhaltungen:
**DE - A - 2 818 529**
**DE - A - 2 853 842**
**FR - A - 2 497 027**
**FR - A - 2 512 608**
**US - A - 4 298 988**

(73) Patentinhaber: **ANT Nachrichtentechnik GmbH,
Gerberstrasse 33, D-7150 Backnang (DE)**

(72) Erfinder: **Magnus, Jürgen, Dipl.-Ing., Sonnenhalde 24,
D-7151 Heutensbach (DE)**

(74) Vertreter: **Wiechmann, Manfred, Dipl.-Ing., ANT
Nachrichtentechnik GmbH
Gerberstrasse 33 Postfach 11 20, D-7150 Backnang (DE)**

## Beschreibung

Die vorliegende Erfindung betrifft ein Verfahren zum Einstellen und Regeln der Frequenz eines Signalgenerators mit einem spannungsgesteuerten Oszillator, einer Messstufe, mindestens einem Zähler unter Zuhilfenahme eines Mikroprozessors mit Programmspeicher (PROM) und Schreib-Lese-Speicher (RAM), bei dem durch die Messstufe die Frequenz des spannungsgesteuerten Oszillators während einer vom Mikroprozessor erzeugten konstanten Torzeit gezählt wird, ein durch die Zählung erzeugtes binäres Muster mit einem gespeicherten Sollwert-Muster verglichen und daraus Vorzeichen und ein binäres Muster für die Grösse der Abweichung bestimmt werden, und bei dem über ein Schaltglied eine Spannung, deren Polarität abhängig ist vom Vorzeichen der Abweichung, auf ein RC-Glied und danach auf das Stellglied des spannungsgesteuerten Oszillators gegeben wird.

Eine Anordnung zum Durchführen dieses Verfahrens ist bekannt aus der US-A-42 98 988. Dort ist allerdings nicht näher ausgeführt, in welcher Weise das binäre Muster für die Grösse der Abweichung in ein pulsbreites moduliertes Signal umgewandelt wird. Aufgabe der vorliegenden Erfindung ist es daher, weitere Verfahrensschritte für die Verwertung des genannten binären Musters zur Regelung eines einstellbaren Oszillators anzugeben.

Die Lösug dieser Aufgabe ist dadurch gekennzeichnet, dass mit dem binären Muster für die Grösse der Abweichung ein Abweichungs-Zähler voreingestellt und danach mit Hilfe eines periodischen Eingangssignals schrittweise auf Null zurückgesetzt wird, dass bei Beginn dieses Rücksetzens das Schaltglied geschlossen und bei Ende des Rücksetzens geöffnet wird.

Eine vorteilhafte Weiterbildung und eine Anordnung zum Duchführen des Verfahrens sind in weiteren Ansprüchen beschrieben.

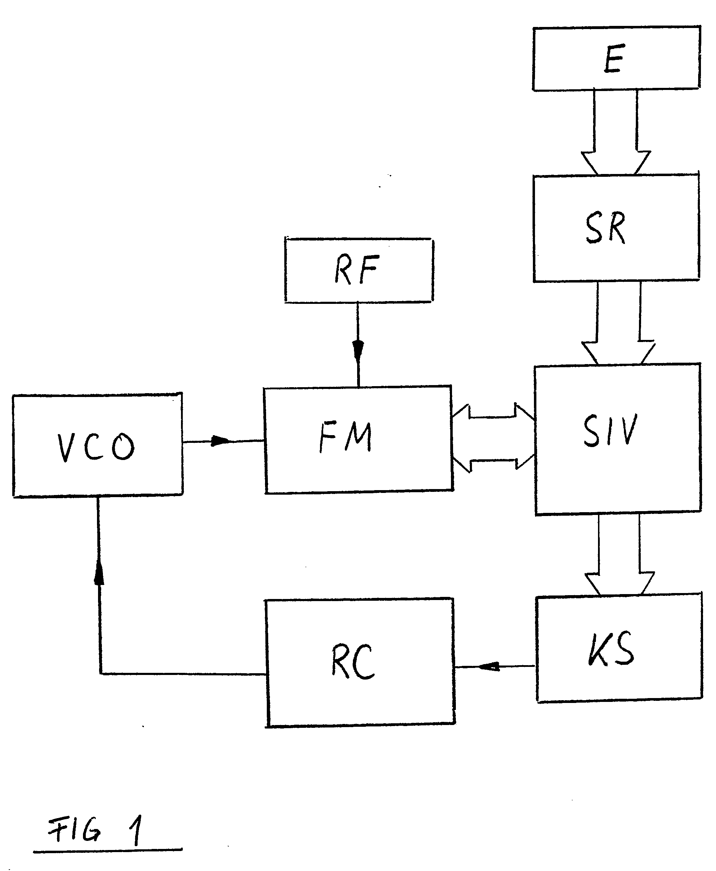

Die Erfindung soll jetzt anhand der Figur näher erläutert werden. Für die Eingabe, Steuerung und den Soll-/Ist-Vergleich wird ein Mikroprozessor eingesetzt. Die Messfrequenz wird durch einen Binärzähler (FM) ausgezählt, dessen Stufenzahl von der geforderten Genauigkeit bestimmt wird. Die Torzeit wird von dem Referenzoszillator des Mikroprozessors (RF) abgeleitet, der mit einem hochgenauen Quarz bestückt ist. Die Eingabe (E) kann in beliebiger Form als Frequenz, Kanalzahl oder ähnliches vom Prozessor direkt in einen binären Sollwert umgerechnet werden (SR), der dann mit dem Messwert verglichen werden kann (S/V). Der ermittelte Differenzbetrag und die Vorzeichenauswertung steuern einen Regelspannungskonverter (D/A-Konverter) (KS). Dieser Konverter regelt seinerseits den spannungsunabhängigen Oszillator (VCO) über das Schleifenfilter (RC) auf seine Sollfrequenz. Will man die Genauigkeit über den Faktor $10^3$ treiben, benötigt man einen A/D-Wandler mit höherer als der üblichen Auflösung. Zum Beispiel ergibt ein 20-stufiger Zähler eine Genauigkeit von $2^{20}$, d.h. angenähert $10^6$. Es wurde deshalb ein anderer Weg beschritten, um aus dem Differenzbitmuster eine Regelspannung zu gewinnen. Das aus dem Soll-/Istwert-Vergleich gewonnene Bitmuster wird in einen Zähler geladen. Dieser Zähler wird dann mit dem periodischen Signal des Referenzoszillators (RF) zurückgezählt, bis jener bei Erreichen des Zählerstandes Null ein Signal abgibt. Die Zeitdifferenz vom Start des Rückzählvorganges bis zum Nulldurchgang des Zählers (FM) ist ein Mass für die Ablage der Ist-Frequenz von der Sollfrequenz. Zusammen mit der aus dem Soll-Istwert-Vergleich gewonnenen Vorzeicheninformation bestimmt sich Betrag und Richtung der Regelspannungskorrektur. Diese wird über einen Analogkanalschalter und nachfolgendem RC-Glied dem Oszillator zugeführt. Erst wenn durch Eigenentladung des RC-Gliedes, Temperaturschwankung oder Änderung der Versorgungsspannung die Frequenzen sich um mehr als 1 Bit geändert haben, wird nachgeregelt, d.h. die Istfrequenz schwankt mit $\pm$ 1 Bit um die Sollfrequenz. Um den Schaltungsaufwand klein zu halten, wurde für die Frequenzzählung und Gewinnung der Zeitdifferenz der gleiche Zähler in aufeinanderfolgenden Vorgängen verwendet. Der Fangbereich der nach der Erfindung aufgebauten Frequenzregel-Schleifen ist überaus gross von der Frequenz Null bis zur maximalen Grenzfrequenz der Zählerbausteine, bei entsprechend gewählter Torzeit, so dass der Bereich im wesentlichen vom Durchstimmbereich des spannungsgesteuerten Oszillators abhängt.

## Patentansprüche

1. Verfahren zum Einstellen und Regeln der Frequenz eines Signalgenerators mit einem spannungsgesteuerten Oszillator (VCO), einer Messstufe (FM), mindestens einem Zähler unter Zuhilfenahme eines Mikroprozessors mit Programmspeicher (PROM) und Schreib-Lese-Speicher (RAM), bei dem durch die Messstufe (FM) die Frequenz des spannungsgesteuerten Oszillators (VCO) während einer vom Mikroprozessor erzeugten konstanten Torzeit gezählt wird, ein durch die Zählung erzeugtes binäres Muster mit einem gespeicherten Sollwert-Muster verglichen und daraus Vorzeichen und ein binäres Muster für die Grösse der Abweichungen bestimmt werden, und bei dem über ein Schaltglied eine Spannung, deren Polarität abhängig ist vom Vorzeichen der Abweichung, auf ein RC-Glied (RC) und danach auf das Stellglied des spannungsgesteuerten Oszillators (VCO) gegeben wird, dadurch gekennzeichnet, dass mit dem binären Muster für die Grösse der Abweichung ein Abweichungs-Zähler (FM) voreingestellt und danach mit Hilfe eines periodischen Eingangssignals schrittweise auf Null zurückgesetzt wird, dass bei Beginn dieses Rücksetzens das Schaltglied geschlossen und bei Ende des Rücksetzens geöffnet wird.

2. Verfahren nach Anspruch 1, dadurch gekennzeichnet, dass es über den Mikroprozessor gleichzeitig für die Frequenzregelung mehrerer spannungsgesteuerter Oszillatoren angewendet wird.

3. Anordnung zum Durchführen eines Verfahrens zum Einstellen und Regeln der Frequenz eines Signalgenerators mit einem spannungsgesteuerten Oszillator (VCO), einer Messstufe (FM), mindestens einem Zähler unter Zuhilfenahme eines Mikroprozessors mit Programmspeicher (PROM) und Schreib-Lese-Speicher (RAM), bei dem durch die Messstufe (FM) die Frequenz des spannungsgesteuerten Oszillator (VCO) während einer vom Mikroprozessor erzeugten konstanten Torzeit gezählt wird, ein durch die Zählung erzeugtes binäres Muster mit einem gespeicherten Sollwert-Muster verglichen und daraus Vorzeichen und ein binäres Muster für die Grösse der Abweichung bestimmt werden, und bei dem über ein Schaltglied eine Spannung, deren Polarität abhängig ist vom Vorzeichen der Abweichung, auf ein RC-Glied (RC) und danach auf das Stellglied des spannungsgesteuerten Oszillators (VCO) gegeben, mit dem binären Muster für die Grösse der Abweichung ein Abweichungs-Zähler (FM) voreingestellt und danach mit Hilfe eines periodischen Eingangssignals schrittweise auf Null zurückgesetzt wird, und bei Beginn dieses Rücksetzens das Schaltglied geschlossen und bei Ende des Rücksetzens geöffnet wird, dadurch gekennzeichnet, dass der Zähler in der Messstufe zur Zählung der Frequenz des spannungsgesteuerten Oszillators und der Abweichungszähler ein- und derselbe sind.

## Claims

1. A method for the tuning and the control of the frequency of a signal generator having a voltage-controlled oscillator (VCO), a measuring stage (FM), at least one counter utilizing a microprocessor having a program memory (PROM) and a read/write memory (RAM), wherein by means of the measuring stage (FM), the frequency of the voltage-controlled oscillator (VCO) is counted during a constant gate time interval generated by the microprocessor, a binary pattern generated by the counting is compared with a set-point pattern stored in memory, and from that the algebraic sign (+ or −) and a binary pattern for the magnitude of the deviations are determined, and wherein, via a switching element, a voltage, the polarity of which is dependent on the algebraic sign of the deviation, is fed to a resistor-capacitor element (RC) and subsequently to the control element of the voltage-controlled oscillator (VCO), characterized in that on the basis of the binary pattern for the magnitude of the deviation, a deviation counter (FM) is pre-adjusted and subsequently reset to zero in increments with the aid of a periodic input signal, and that the switching element is closed at the beginning of this resetting and is opened at the end of the resetting.

2. A method as defined by claim 1, characterized in that, via the microprocessor, it is simultaneously used for regulating the frequency of a plurality of voltage-controlled oscillators.

3. An apparatus for performing a method of tuning and controlling the frequency of a signal generator having a voltage-controlled oscillator (VCO), a measuring stage (FM), at least one counter utilizing a microprocessor having a program memory (PROM) and a read/write memory (RAM), wherein by means of the measuring stage (FM), the frequency of the voltage-controlled oscillator (VCO) is counted during a constant gate time interval generated by the microprocessor, a binary pattern generated by the counting is compared with a set-point pattern stored in memory, and from that the algebraic sign (+ or −) and a binary pattern for the magnitude of the deviations are determined, and wherein, via a switching element, a voltage, the polarity of which is dependent on the algebraic sign of the deviation, is fed to a resistor-capacitor element (RC) and subsequently to the control element of the voltage-controlled oscillator (VCO), a deviation counter (FM) is pre-adjusted on the basis of the binary pattern for the magnitude of the deviation and is subsequently reset to zero in increments with the aid of a periodic input signal, and the switching element is closed at the beginning of this resetting and is opened at the end of the resetting, characterized in that the counter in the measuring state for counting the frequency of the voltage-controlled oscillator, and the deviation counter, are one and the same.

## Revendications

1. Procédé pour prescrire et régler la fréquence d'un générateur de signaux, comportant un oscillateur à fréquence commandée par la tension (VCO), un étage de mesure (FM), au moins un compteur aidé d'un microprocesseur comprenant une mémoire de programmes (PROM) et une mémoire de lecture écriture (RAM), dans lequel la fréquence de l'oscillateur à fréquence commandée par la tension (VCO) est comptée par l'étage de mesure (FM) pendant une durée de mesure constante établie par le microprocesseur, dans lequel un modèle binaire, établi par le comptage, est comparé avec un modèle de valeur prescrite mémorisé et dans lequel on en déduit un signe et un modèle binaire pour la valeur des écarts, et dans lequel, par l'intermédiaire d'un élément de circuit, une tension, dont la polarité dépend du signe de l'écart, est envoyée à un élément RC (RC), puis à l'élément de positionnement de l'oscillateur à fréquence commandée par la tension (VCO), caractérisé en ce qu'un compteur d'écart (FM) est préaffiché avec le modèle binaire obtenu pour la valeur de l'écart, puis remis par pas au zéro à l'aide d'un signal d'entrée périodique; et en ce qu'au début de cette remise au zéro, l'élément de circuit est fermé et, à la fin de cette remise au zéro, ouvert.

2. Procédé selon la revendication 1, caractérisé en ce que, par l'intermédiaire du microprocesseur, on emploie simultanément pour la régulation de fréquence plusieurs oscillateurs à fréquence commandée par la tension.

3. Dispositif pour l'exécution d'un procédé pour prescrire et régler la fréquence d'un générateur de signaux, comportant un oscillateur à fréquence commandée par la tension (VCO), un étage de mesure (FM), au moins un compteur aidé d'un microprocesseur comprenant une mémoire de programmes (PROM) et une mémoire de lecture écriture (RAM), dans lequel la fréquence de l'oscillateur à fréquence commandée par la tension (VCO) est comptée par l'étage de mesure (FM) pendant une durée de mesure constante établie par le microprocesseur, dans lequel un modèle binaire, établi par le comptage, est comparé avec un modèle de valeur prescrite mémorisé et dans lequel on en déduit un signe et un modèle binaire pour la valeur des écarts, et dans lequel, par l'intermédiaire d'un élément de circuit, une tension, dont la polarité dépend du signe de l'écart, est envoyée à un élément RC (RC), puis à l'élément de positionnement de l'oscillateur à fréquence commandée par la tension (VCO); dans lequel un compteur d'écart (FM) est préaffiché avec le modèle binaire obtenu pour la valeur de l'écart, puis remis par pas au zéro à l'aide d'un signal d'entrée périodique, et dans lequel, au début de cette remise au zéro, l'élément de circuit est fermé et, à la fin de cette remise au zéro, ouvert, caractérisé en ce que le compteur prévu dans l'étage de mesure pour le comptage de la fréquence de l'oscillateur à fréquence commandée par la tension et le compteur d'écart sont un seul et même compteur.

FIG 1